Europäisches Patentamt

European Patent Office

Office européen des brevets

(19)

(11) Publication number: **0 018 178**
**B1**

(12) # EUROPEAN PATENT SPECIFICATION

(45) Date of publication of patent specification: **18.01.84**

(51) Int. Cl.³: **H 01 L 21/76**

(21) Application number: **80301166.7**

(22) Date of filing: **11.04.80**

(54) **Process for producing a composite body for a semiconductor integrated circuit.**

(30) Priority: **13.04.79 JP 44365/79**

(43) Date of publication of application:
**29.10.80 Bulletin 80/22**

(45) Publication of the grant of the patent:
**18.01.84 Bulletin 84/3**

(84) Designated Contracting States:
**DE GB NL**

(56) References cited:
**DE - A - 2 620 814
GB - A - 1 436 434**

(73) Proprietor: **Hitachi, Ltd.**
**5-1, Marunouchi 1-chome
Chiyoda-ku Tokyo 100 (JP)**

(72) Inventor: **Horiuchi, Junichiro**
**1-36-4302 Nishinarusawa Hitachi
Ibaraki (JP)**
Inventor: **Yagi, Hideyuki**
**1-6-4, Takasuzu
Hitachi, Ibaraki (JP)**

(74) Representative: **Paget, Hugh Charles Edward et al,
MEWBURN ELLIS & CO. 2/3 Cursitor Street
London EC4A 1BQ (GB)**

Courier Press, Leamington Spa, England.

## Process for producing a composite body for a semiconductor integrated circuit

This invention relates to a process for producing a composite body (hereinafter also referred to as a substrate) for a semiconductor integrated circuit, having a number of monocrystalline semiconductor island regions in which circuit elements are to be formed and a polycrystalline support for the island regions.

In a semiconductor integrated circuit, circuit elements such as resistors, diodes, transistors, thyristors and the like are formed integrally in island regions and must be electrically separated from each other. Thus, a large number of island regions are electrically insulated from each other and from a support region which supports them. One known insulating technique uses dielectric materials, and a substrate prepared according to this method is called a dielectric insulator separated substrate (hereinafter referred simply to as DI substrate).

The DI substrate, however, tends to suffer bending deformations during its preparation and upon the production of semiconductor integrated circuits in it. This deformation causes various defects including cracks in the substrate, reduced accuracy of metal deposition for the electrodes, degradation of the withstand voltage and fluctuations in characteristics of the circuit elements.

Our USA Patents Nos. 3,967,309, 4,017,341, 4,079,506 and 4,173,674 describe in detail causes for the bending deformations of the DI substrate and propose a countermeasure therefor. There are two types of bending deformation of the DI substrate. In one the DI substrate is deformed convexly toward the side having the monocrystalline semiconductor island regions. In the other, the DI substrate is deformed convexly toward the side having the polycrystalline semiconductor support region. The former type is caused by a difference in thermal expansion coefficient between the monocrystalline island regions and the polycrystalline support region. In the latter type, the deformation results from the wedging action caused by oxygen diffused into the polycrystalline support region during the diffusion of a p- or n-type impurity into desired parts of monocrystalline island regions.

The patents mentioned above propose the provision of a film for preventing the diffusion of oxygen into the surface of the polycrystalline layer of the support region and/or a film for compensating for the difference in thermal expansion coefficient between the island regions and the support region.

USA Patent No. 4,173,674 (corresponding to DE—A—2620814) proposes the provision of a thin polycrystalline outer layer, which is formed by reducing a thick polycrystalline layer having a thickness before reduction of generally at least 30 μm. If this thickness is too small, part of the inner thick polycrystalline layer may be exposed by further reduction of the thickness of the outer layer required because of the bending of the substrate. When the thick inner polycrystalline layer is exposed in this way, the substrate will be deformed by the action of oxygen during doping with an impurity.

In general the ultimate thickness of the substrate is about 400 to 500 μm. The substrates produced by the process disclosed in, for example, USA Patent 4,173,674 have a bend of 60 to 100 μm, when the diameter of the substrate is 50 mm. Before the polishing of the monocrystalline layer to form the island regions, the opposite face of the substrate is first polished to obtain a flat surface. In order to carry out the second polishing, i.e. the reduction in thickness of the monocrystalline layer, the substrate is supported by suction applied to the flat surface of the polycrystalline layer.

Since non-uniform growth of the polycrystalline layer tends to occur, in addition to the machining tolerance of the first polishing the overall variation in thickness of the polycrystalline layer removed by the first polishing is about 30 μm or more. The variation in local thickness of the body thus caused by the first polishing will increase as the diameter of the body increases. Accordingly, if the outer polycrystalline layer is 30 μm thick or more, which is considered to be a sufficient thickness to cover the local variations of the thickness of the polycrystalline layer removed by the first polishing there is a possibility that a part of this thick polycrystalline outer layer may remain insufficiently removed by the first polishing. Therefore, this remaining part of the thick polycrystalline outer layer can be a cause of deformation of the substrate due to oxygen diffusion during doping with an impurity.

It is an object of the present invention to provide a process of manufacturing a composite body for a semiconductor integrated circuit in which the possibility of a thick polycrystalline layer being exposed as the outer surface is eliminated.

The invention as claimed is intended to provide a remedy. It consists in that a lamination of thin second polycrystalline layers and dielectric films interposed therebetween is formed as an outer layer on the first polycrystalline layer(s) described above with a further dielectric film separating the lamination from the first polycrystalline layer(s).

Thin polycrystalline layers each, for example, 10 μm thick can be produced by a process for producing a polycrystalline layer on a dielectric film from the gas phase, such as is disclosed in USP 4,017,341. Therefore, if, for example, more than three layers in this lamination are provided, although a thickness reduction of about 30 μm may occur in order to provide the body with a flat surface, a part of the lamination consisting of the thin polycrystalline layers still remains and everywhere a polycrystalline layer of less than 10 $\mu$m thick is exposed. Accordingly, exposure of the generally thicker inner (first) polycrystalline layer(s), which adjoin the remaining thin polycrystalline layers through a dielectric film can be avoided. The thickness chosen for the lamination is that necessary to accommodate the amount of machining, this being determined for example by the local differences in thickness of the body and the machining tolerance.

An embodiment of the invention will now be described by way of example with reference to the accompanying drawings, in which:—

Figure 1 is an explanatory view of a substrate embodying the invention showing bending deformation and thickness of various parts, and

Figure 2 is a partial cross-sectional view of a substrate in one embodiment of the present invention.

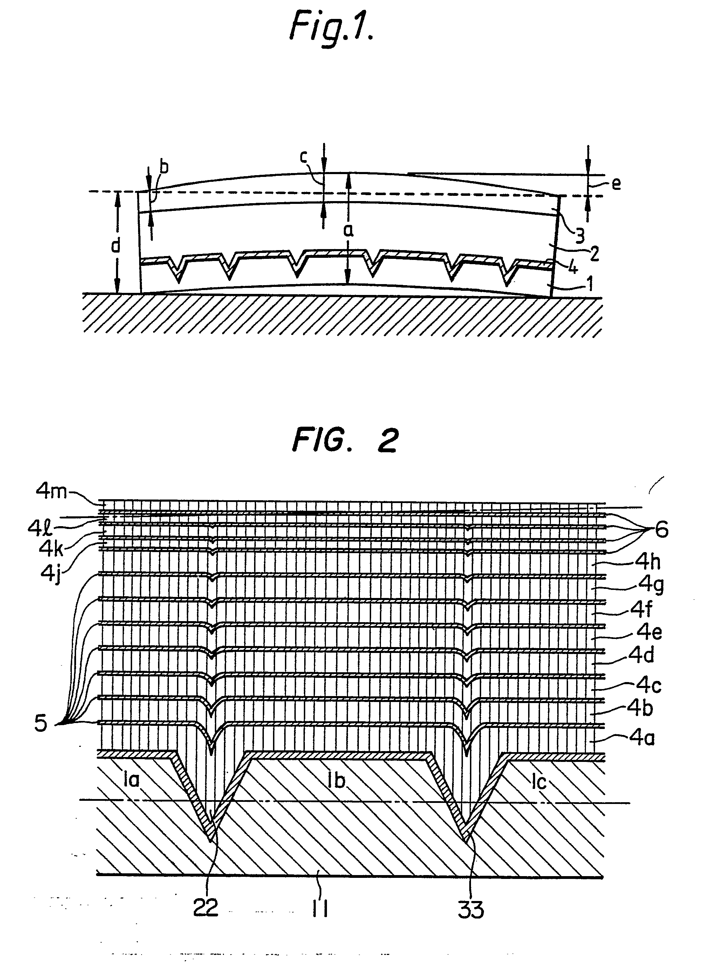

As shown in Figure 1, a substrate of the present invention consists of a monocrystalline silicon wafer 1, with a polycrystalline silicon region 2 superimposed on a dielectric film 4 above the layer 1 and a lamination 3 on the region 2. The lamination 3 consists of at least three thin layers of polycrystalline silicon and dielectric films interposed between the layers.

The substrate has a bending deformation as shown in Figure 1, and its thickness $a$ at its centre is generally slightly larger than its thickness $d$ at its edge, because there is a tendency for the thickness $c$ of the lamination in the centre part of the water to be greater than its thickness $b$ in the peripheral parts. In order to obtain a flat face designated by a broken line, the lamination should be machined or polished with removal of a maximum thickness $e$.

Figure 2 shows in more detail the monocrystalline wafer 11 (corresponding to wafer 1 of Figure 1) polycrystalline layers 4a—4h (corresponding to region 2 of Figure 1) and polycrystalline layers 4j—4m (corresponding to the lamination 3 of Figure 1).

The polycrystalline layer 4a shown in Figure 2 is grown by a process such as is disclosed in USA Patent 4,017,341 or USA Patent 4,079,506 on a dielectric film 33 such as a silicon dioxide film. The dielectric film is formed by a thermal oxidation process, for example, on the surface of the monocrystalline wafer 11 which has grooves 22. The silicon dioxide film 33 functions as an insulating film, so it should have a thickness sufficient to withstand the potentials applied to the integrated circuits to be formed in the island regions 1a—1c.

After the formation of the first polycrystalline layer 4a, oxygen-impermeable dielectric films 5 (e.g. films of silicon dioxide, silicon nitride, aluminium oxide or a combination of two or more of these) and polycrystalline layers 4b—4h are alternately formed by the process for example of USA Patent 4,079,506 or USA Patent 4,017,341. According to 4,079,506 the alternate lamination of polysilicon layers and silicon dioxide films can reduce the bending deformation of the resulting substrate. 4,079,506 proposes that the number of polycrystalline layers and dielectric films should be 3 to 12. In Figure 2, the number of the polycrystalline layers is 8. In one example the thickness of each of the polycrystalline layers 4a—4h was 50 $\mu$m and that of each dielectric film 5 was 0.5 $\mu$m.

There is another method of reducing the bending deformation of the resulting substrate in which a certain amount of oxygen is doped into the polycrystalline layer during the formation of the layer. In this process the number of polycrystalline layers can be made smaller than is proposed in 4,079,506. Typically, only one layer doped with oxygen and having a sufficient thickness can satisfy requirements.

After the formation of the lamination or of a single polycrystalline layer, the lamination consisting of thin polycrystalline layers 4j—4m and dielectric films 6 is formed in the manner disclosed for instance in USA Patent 4,017,341, 4,079,506 or 4,173,674. In one example, the average thickness of each of the polycrystalline layer 4j—4m was 13 $\mu$m and the thickness of each dielectric film 6 ($SiO_2$) was 0.4 $\mu$m. In this example the number of thin polycrystalline layers was four, as illustrated. Accordingly, the total thickness of the outer lamination was 53.2 $\mu$m (13 $\mu$m $\times$ 4 + 0.4 $\mu$m $\times$ 3).

It is most preferred that the thickness x (in $\mu$m) of each thin layer (4j—4m etc.) is $\leqq$ y/40 where y is the ultimate thickness (in $\mu$m) of the substrate. However it can be sufficient if x $\leqq$ y/30.

After formation of the outer lamination, the resulting substrate was subjected to machining (polishing) to obtain a flat face designated by a chain-dot line in Figure 2. During machining (polishing) the monocrystalline substrate surface was supported by a vacuum chuck (not shown). A vacuum chuck is used not only to support the substrate, but also to make the substrate more flat. The supported substrate had a bend of 20 $\mu$m. The polishing was conducted to reduce the thickness of the outer lamination by about 40 $\mu$m at the maximum as shown by the chain-dot line. By employing the outer lamination as described above, the danger of exposure of a thick polycrystalline layer is completely avoided because the polycrystalline layers 4j—4m have a very small thickness.

As a result, the risk of bending deformation due to oxygen diffused into the outer polycrystalline layer is avoided, even when there are local variations in thickness of the substrate and there is a machining tolerance. With the technique disclosed in USA 4,173,674, the outer polysilicon layer needs to have a thickness sufficient to cover the machining tolerance and the local variation in thickness of the substrate, i.e. in this case the thickness of this outer polycrystalline layer should be about 30 $\mu$m or more. If such a thick outer polycrystalline layer is exposed after polishing, it can be a cause of bending deformation of the substrate due to oxygen diffused into the layer.

However, in the present invention, the bending deformation is negligible because the thickness of each of the polycrystalline layers 4j—4m is sufficiently small and the overall thickness of the lamination can cover the local thickness variations of the substrate and the machining tolerance.

After the polishing of the outer lamination, the substrate was turned over and supported by means of a vacuum chuck. Then, the monocrystalline layer 11 was polished to the extent shown by the double-dotted chain-dot line to form island regions 1a—1c each surrounded by a dielectric film 33. The substrate thus prepared was subjected to the desired doping to form the desired circuit components in the island regions. After doping, substantially no deformation due to oxygen diffusion into the outer polycrystalline layer was observed. Accordingly, a high precision circuit pattern could be expected using this substrate.

To summarize, the main advantages of the present invention are as follows:—

(1) It is possible to eliminate bending deformation due to oxygen diffusion into a polycrystalline layer during the impurity doping of island regions.

(2) It is possible to shorten the total machining time to obtain a flat face on the side having the lamination of thin polycrystalline layers. Because each of the layers can have a minimum thickness, the machining of the lamination is finished as soon as a flat surface is obtained, regardless of the thickness remaining of the exposed polycrystalline layers. In the case of US Patent 4,173,674 however, the outer polycrystalline layer must have a sufficient thickness to cover local variations in the thickness of the substrate and the curvature remaining in the substrate as well as a machining tolerance. Consequently, further precise and continual adjustments of the thickness of the outermost polycrystalline layer are required in the machining to obtain a flat surface which is not liable to bending deformation due to oxygen diffusion; this operation takes a lot of time.

## Claims

1. A process for producing a composite body for a semiconductor integrated circuit including a plurality of monocrystalline semiconductor island regions (1a, 1b, 1c) and at least one dielectric film (33) separating the island regions from each other, comprising the steps of:

(a) preparing a composite body having a monocrystalline semiconductor layer (1) which is to provide said island regions and a support which comprises a plurality of polycrystalline semiconductor layers (4a—4m) superposed on the monocrystalline layer (1) with a dielectric film (5) between the monocrystalline layer (1) and the polycrystalline layer (4a) adjacent thereto and between each adjacent pair of said polycrystalline layers, there being an outer plurality of at least three said layers most remote from the monocrystalline layer which are thinner than the or each of the said layers closer to the monocrystalline layer;

(b) treating a first major surface of the composite body, which surface is remote from said monocrystalline layer (1) so as to render said first major surface flat; and

(c) after step (b), treating a second major surface of the composite body which second major surface is an exposed surface of the monocrystalline layer (1) so as to provide said island regions (1a, 1b, 1c), characterized in that in step (a), the said outer plurality of polycrystalline layers most remote from the monocrystalline layer are formed as layers (4j—4m) which are each of thickness x (in $\mu$m), given by

$$x \leqq y/30$$

wherein y is the ultimate thickness (in $\mu$m) of said composite body and that the number and thickness of said outer plurality of layers (4j—4m) are such that the treatment of step (b) does not expose the said polycrystalline layer(s) closer to the monocrystalline layer than said outer plurality of layers.

2. A process according to claim 1 wherein each dielectric film is silicon dioxide, silicon nitride, aluminium oxide or a combination of two or more of these.

3. A process according to claim 1 wherein each dielectric film is of silicon dioxide.

4. A process according to any one of claims 1 to 3 wherein the curvature and/or thickness variation of the composite body is such that said step (b) effects removal of the whole thickness of at least one of said outer plurality of polycrystalline layers (4j—4m) over at least a substantial area of the body.

## Revendications

1. Procédé de production d'un corps composite pour circuit intégré semi-conducteur comportant plusieurs régions (1a, 1b, 1c) constituant des îles semi-conductrices monocristallines et au moins une pellicule diélectrique (33) séparant les unes des autres les régions d'îles, comprenant les opérations suivantes:

(a) préparer un corps composite possédant une couche semi-conductrice monocristalline (1) qui est destinée à constituer lesdites régions d'îles et un support qui comprend plusieurs couches semi-conductrices polycristallines (4a—4m) se superposant sur la couche monocristalline (1), une pellicule diélectrique (5) étant disposée entre la couche monocristalline (1) et la couche polycristalline (4a) qui lui est adjacente et entre les éléments adjacents de chaque paire desdites couches polycristallines, au moins trois dites couches les plus éloignées de la couche monocristalline, formant un groupe extérieur, étant plus minces que la couche ou chacune desdites couches plus proches de la couche monocristalline;

(b) traiter une première surface majeure du corps composite, laquelle surface est éloignée de ladite couche monocristalline (1), de façon à rendre plane ladite première surface majeure; et

(c) après l'opération (b), traiter une deuxième surface majeure du corps composite, laquelle deuxième surface majeure est une surface exposée de la couche monocristalline (1), de façon à constituer lesdites régions d'îles (1a, 1b, 1c), caractérisé en ce que dans l'opération (a), ledit groupe extérieur de couches polycristallines les plus éloignées de la couche monocristalline est formé de couches (4j—4m) qui sont chacune d'une épaisseur $x$ donnée (en microns) par

$$x \leqq y/30$$

où $y$ est l'épaisseur finale (en microns) dudit corps composite, et en ce que le nombre et l'épaisseur des couches (4j—4m) dudit groupe extérieur sont tels que le traitement de l'opération (b) n'expose pas la ou lesdites couches polycristallines qui sont plus proches de la couche monocristalline que les couches dudit groupe extérieur.

2. Procédé selon la revendication 1, où chaque pellicule diélectrique est formée de dioxyde de silicium, de nitrure de silicium, d'oxyde d'aluminium ou d'une combinaison de deux ou plus de deux de ces substances.

3. Procédé selon la revendication 1, où chaque pellicule diélectrique est formée de dioxyde de silicium.

4. Procédé selon l'une quelconque des revendications 1 à 3, où la courbure et, ou bien, la variation d'épaisseur du corps composite sont telles que ladite opération (b) réalise l'enlèvement de toute l'épaisseur d'au moins une desdites couches polycristallines (4j—4m) du groupe extérieur sur au moins une aire notable du corps.

**Patentansprüche**

1. Verfahren zur Herstellung eines zusammengesetzten Körpers für eine integrierte Halbleiterschaltung, umfassend eine Vielzahl von einkristallinen Halbleiter-Inselbereichen (1a, 1b, 1c) und mindestens einen die Inselbereiche voneinander trennenden dielektrischen Film (33) umfassend die folgenden Schritte:

(a) Vorbereiten eines zusammengesetzten Körpers mit einer einkristallinen Halbleiterschicht (1), die die Inselbereiche bilden soll, und einem Träger, der eine Vielzahl von auf der einkristallinen Schicht (1) aufgebauten polykristallinen Halbleiterschichten (4a bis 4m) umfaßt, wobei zwischen der einkristallinen Schicht (1) und der dieser benachbarten polykristallinen Schicht (4a) sowie zwischen jedem Paar von benachbarten polykristallinen Schichten ein dielektrischer Film (5) angeordnet ist, und wobei eine äußere Mehrzahl von mindestens drei der genannten, von der einkristallinen Schicht am weitesten entfernten Schichten vorhanden ist, die dünner sind als die oder jede der einkristallinen Schicht nähere Schicht;

(b) Behandeln einer von der einkristallinen Schicht (1) abgewandten ersten Hauptfläche des zusammengesetzten Körpers, so daß diese eben wird; und

(c) nach dem Schritt (b) Behandeln einer eine freiliegende Oberfläche der einkristallinen Schicht (1) bildenden zweiten Hauptfläche des zusammengesetzten Körpers zur Bildung der Inselbereiche (1a, 1b, 1c), dadurch gekennzeichnet, daß in dem Schritt (a) die besagte äußere Mehrzahl der von der einkristallinen Schicht am weitesten entfernten polykristallinen Schichten als Schichten (4j bis 4m) gebildet werden, die jeweils eine Dick x (in $\mu$m) ausgedrückt durch

$$x \leqq y/30$$

aufweisen, wobei y die endgültige Dicke (in $\mu$m) des zusammengesetzten Körpers ist, und daß die Anzahl und Dicke der besagten äußeren Mehrzahl von Schichten (4j bis 4m) so gewählt sind, daß die Behandlung entsprechend dem Schritt (b) diejenige polykristalline Schicht bzw. diejenigen polykristallinen Schichten nicht freilegt, die näher an der einkristallinen Schicht liegt bzw. liegen als die besagte äußere Mehrzahl von Schichten.

2. Verfahren nach Anspruch 1, wobei jeder dielektrische Film aus Siliziumdioxid, Siliziumnitrid, Aluminiumoxid oder einer Kombination von zwei oder mehreren dieser Materialien besteht.

3. Verfahren nach Anspruch 1, wobei jeder dielektrische Film aus Siliziumdioxid besteht.

4. Verfahren nach einem der Ansprüche 1 bis 3, wobei die Krümmungs- und/oder Dickenschwankung des zusammengesetzten Körpers so ist, daß der Schritt (b) die Entfernung mindestens einer der besagten äußeren Mehrzahl von polykristallinen Schichten (4j bis 4m) in gesamter Dicke über mindestens einen wesentlichen Bereich des Körpers bewirkt.

# *Fig.1.*

# FIG. 2